# EUROPEAN PATENT SPECIFICATION

(11) **EP 2 287 921 B1**
(45) Date of publication and mention of the grant of the patent: **07.12.2011**
(21) Application number: 09164561.4
(22) Date of filing: 03.07.2009
(51) Int. Cl.: H01R 12/59, H01L 31/048

(54) **Junction box for connecting a solar cell, electrical diode, guiding element and fixing means**
Verteilerdose zum Anschließen einer Solarzelle, elektrische Diode, Führungselement und Befestigungsmittel
Boîte de jonction pour connecter une cellule solaire, diode électrique, élément de guidage et supports de fixation

(43) Date of publication of application: 23.02.2011
(73) Proprietor: Tyco Elektronics AMP GmbH, 64625 Bensheim (DE)
(72) Inventor: Ilchev, Lazar, 1836 Sofia (BG)
(74) Representative: Patentanwaltskanzlei WILHELM & BECK

(56) References cited:
- EP-A- 1 729 369
- EP-A- 1 777 754
- WO-A-2008/095669
- GB-A- 2 350 497
- US-A- 5 118 361
- US-A- 5 743 747
- US-A- 5 928 437

## Description

The invention refers to a junction box for connecting a solar cell according to claim 1.

International patent application WO 2009/045318 A1 discloses a low profile photovoltaic box that is used for connecting solar cells. The box comprises diodes that are disposed on heat sinks and that are used for electrically connecting conductors of the solar cells.

GB 2 350 497 A discloses an automotive electrical connector for flexible printed circuits. A flexible printed circuit board is wrapped wound a rigid card and this is inserted along a guide channel into a cavity into a backplane, where it makes contact with a second flexible printed circuit board. Elastomeric members push the two printed circuit boards together. The card may have conductive portions so that the system can detect that the card is properly inserted. An opening for a FPC may have rounded edges so that the FPC is not damaged as it enters. Two FPCs can be wrapped around a rod. A heatsink can be made by laminating two conductive and two insulating layers. The tracks of a FPC can be connected to external conductors.

The US Patent US 5,743,747 describes a connector having a pair of structural substrates that each contain mechanically raised dimples and adjacent mating flexible interconnect circuits. The structural substrate has one or more structural dimples formed therein that protrude above one surface. A metallization pattern on the substrate overlays each of the structural dimples to provide additional structural support. The flexible interconnect circuits each comprise a dielectric substrate fabricated as a flat flexible circuit having conductive traces formed on top and bottom sides thereof, respectively, that terminate in contact areas. The conductive traces are configured to conform to the shapes of the respective dimples of the structural substrates when they are mated. The mated flexible interconnect circuits are compressed by the structural substrates using plates or other securing members so that contact therebetween is made by the conductive traces adjacent the contact areas. The contact areas of the flexible interconnect circuits conform to and mate with the structural dimples without the need to form dimples in the flexible interconnect circuits.

WO 2008/095669 A1 discloses a junction and connecting box for a solar module. The solar module having flexible flat conductor strips that protrude from the surface of the solar module. The junction and connecting box comprises, on its side facing the solar module when assembled, an introduction opening for at least one flexible flat conductor strip of the solar module and a housing for installing on the solar module and a junction device that is arranged in the housing for the flexible flat conductor strip. Said junction device comprises a deviation lever and an electric contact clip that are actuated when the box is installed on the solar module in order to bend the flat conductor strip and to establish contact therewith.

EP 1 729 369 A2 describes a connecting device for connecting electrical foil conductors. The connecting device connects at lease one electrical foil conductor to at least one connection line. The connecting device comprises a connector housing heaving at lease one connection line through-hole and at least one foil conductor through-hole. Arranged in the connector housing is an intermediate connecting arrangement heaving at least one intermediate connector, which extends between the connection line through-hole and the foil conductor through-hole and has a connection line-connection region which is adjacent to the connection line through-hole for connection to the connection line, which is guided through the connection line through-hole into the interior of the connector housing, and a current conductor, which extends to the vicinity of the foil conductor through-hole and has a foil conductor-connection region for connection to the foil conductor, which is guided through the foil conductor through opening into the interior of the connector housing. The current conductor comprises a current conductor region configured for applying a foil conductor-connection region. There is provided a clamping spring configured for resilient attachment to the current conductor region and foil conductor connection region adjacent thereto and for clamping thereby caused, of the foil conductor connection region to the current conductor region. The connecting device of this type is suitable for electrical connection of solar cells of a solar cell battery module to external current consumers and may be produced in a particularly simple and beneficial manner.

EP 1 777 754 A1, that discloses a junction box according to the preamble of claim 1 describes a connection device having a diode for connecting an electrical conductor to a connecting lead. The connection device comprises a connector housing and an intermediate connection arrangement arranged in the connector housing having a first connection area for connecting the connecting lead and a second connection area for connecting the electrical conductor. The intermediate connection arrangement comprises a substrate arrangement having an electrical conductor structure, a thermal conduction structure and at least one diode. The diode is configured as a flat diode having two substantially flat opposing main faces. The diode is connected to the electrical conductor structure and is connected to the thermal conduction structure by at least one of its main phases. The conductor structure is used for the electrical connection of the first connection area and a second connection area, whereas the thermal conduction structure is configured to dissipate thermal energy from the diode.

A task of the invention is to provide a junction box with an improved structure.

The proposed junction box has the advantage that a larger variation in the assembly of the junction box is possible. This advantage is achieved by using diodes with electroconductive diode foil strips as electrical connection contacts of the electrical diode. The electroconductive diode foil strip is part of the electrical diode. By using the diode foil strips as electrical connection, it is possible to bend the diode foil strips as it may be advantageous. The diodes can be arranged in different orientations, whereby the diode foil strips are bent, respectively. Additionally, a guiding element is provided, whereby the diode foil strip is guided over a diode foil strip guiding surface of the guiding element and the guiding element is connected to the housing. Therefore, diode foil strips provide more flexibility in comparison to wire conductors. The diode foil strip is made of any kind of material that is electro conductive and suitable for undergoing several bending cycles without the risk of being damaged. Further, the diode foil strip material is also characterized by its bending properties, which are such that once bended from an original shape into a specific shape, it will remain in said specific shape without the risk of it self-returning to its said original shape. A preferable thickness of the diode foil strip from the point of view of material optimization is between 0.1 to 1.0 mm, more preferably 0.2 to 0.6 mm from the point of view of reducing the force during the bending process.

The width of the diode foil strip is not necessarily determined by the width of the diode as such. Accordingly, the width of the diode foil strip can either be greater or smaller than the width of the diode body depending on the circumstances. For example, in order to further improve the heat distribution the diode foil strip width can be chosen to be larger than the width of the diode body.

In a further embodiment, the proposed guiding element for the electrical diode foil strip has at least a partially spherical guiding surface, preferably a cylindrical surface, whereby the diode foil strip can be attached to the guiding surface and fixed to the guiding element. The guiding element may preferably be connected to a housing of a junction box in a moveable manner. Using a guiding element with a guiding surface has the advantage that the shape of the foil strip is determined and a large guiding face is provided for guiding the foil strip. The proposed guiding element provides a safe fixing of the foil strip.

Further embodiments of the present invention are disclosed in the dependent claims.

In a further embodiment, the proposed fixing means for fixing an electroconductive foil strip to a guiding element is a clamp element which is basically Ω (omega shaped. The clamp element may have a conductive strip for connecting the clamp element to a contact point. The provided clamp element has the advantage that it provides a reliable and simple fixing of the foil strip to the guiding element.

In an embodiment of the junction box, the diode foil strip is fixed to the housing. This provides a safe guiding of the diode foil strip.

In a further embodiment, the diode foil strip may be fixed to the guiding element. This provides a safe guiding of the diode foil strip.

In a further embodiment, the guiding element is connected to the housing in a slidable manner. This provides a better flexibility in determining the position of the guiding element within the junction box.

In a further embodiment, the guiding element has at least a partially cylindrical guiding surface, whereby the diode foil strip is attached to the guiding surface. The cylindrical guiding surface has the advantage of providing a large guiding surface for the diode foil strip. This improves the fixing of the diode foil strip.

In a further embodiment, a conductor of a solar cell is connected to the diode foil strip. The connecting of the conductor of the solar cell with the diode foil strip provides a simple construction of the junction box. In a further embodiment, the conductor of the solar cell is preferably fixed by a clamping element to the guiding element. Although this features simplifies the construction of the junction box because the conductor of the solar cell is fixed to the guiding element and preferably directly electrically connected to the diode foil strip on the guiding element.

In a further embodiment, the guiding element comprises a conductor element that is fixed to the guiding element and that is used for electrically contacting a contact point. By providing the conductor element, an electrical connection is provided between the diode foil strip and the contact point.

In a further embodiment, the diode foil strip is fixed to the housing by means of a clip or a pin, whereby the clip or pin protrudes the foil strip. This provides a simple and reliable connection means for fixing the foil strip to the housing.

Other features and advantages of the present invention will become apparent from the following more detailed description of the preferred embodiments, taken in conjunction with the accompanying drawings which illustrate, by way of example, the principles of the invention.
Figure 1 illustrates a Schottky diode with two foil strips;
Figure 2 illustrates a clamping element;
Figure 3 illustrates a guiding element;
Figure 4 illustrates a section of a housing with a T-rail system;
Figure 5 illustrates a schematic view of a section of a junction box with several guiding elements;
Figure 6 illustrates a further embodiment of a junction box;
Figure 7 shows another embodiment of a junction box;
Figure 8 illustrates a partial cross-section through a first and a second guiding element of the junction box of figure 7;
Figure 9 shows a further embodiment of a clamping element;
Figure 10 shows a further embodiment of a clamping element;
Figure 11 shows the clamping element of Figure 10 fixed to a guiding element;
Figure 12 shows a further embodiment of a clamping element;
Figure 13 shows a guiding element that can be used for fixing the clamping element of Figure 12;
Figure 14 shows a further embodiment of a clamping element;
Figure 15 shows a further embodiment of a clamping element;
Figure 16 shows a further embodiment of a clamping element;
Figure 17 shows a further embodiment of a clamping element;
Figure 18 shows a further embodiment of a clamping element;
Figure 19 shows a foil strips fixed by plastic clips;
Figure 20 shows a foil strips fixed by plastic pins;
Figure 21 shows an embodiment of connecting several diodes with a foil strip;
Figure 22 shows an embodiment with a ring chain of diodes;
Figure 23 shows an embodiment of a bended foil strip.

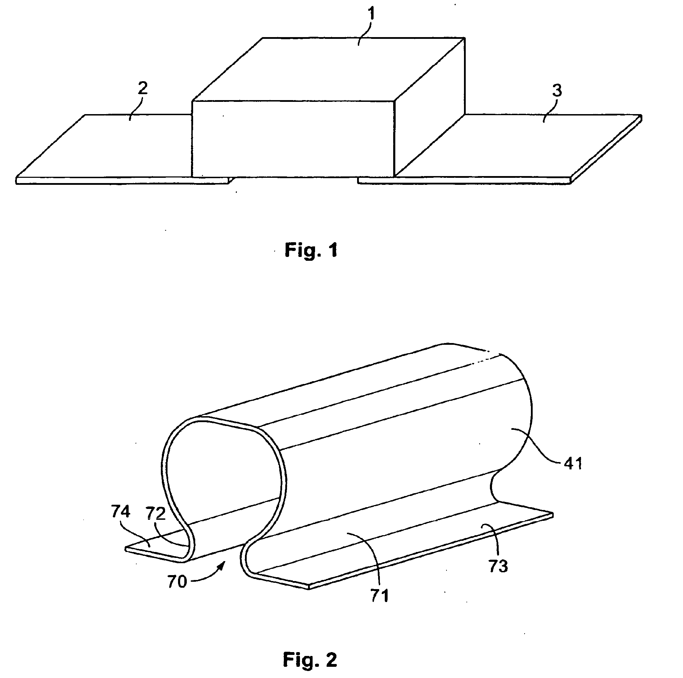

Figure 1 illustrates a schematic view of an electrical diode 1 which is in this example embodied as a Schottky diode with a first and a second electrical connection contact 2, 3 in the shape of electroconductive foil strips. The foil strips 2, 3 may be part of the diode 1 or the diode 1 may be electrically connected, e.g. by solder contacts to the foil strips 2, 3. Depending on the embodiment, the diode 1 may comprise only one electroconductive foil strip 2, 3, whereby the other electrical connection contact is constructed as a wire conductor. Using electroconductive foil strips as electrical connection contacts provides the advantage that the foil strip is less sensitive with respect to bending processes during the production of a junction box. The foil strips may have a width of 5 to 6 mm. Bending the foil strip causes less stress on the diode 1 in comparison to bending a wire conductor as an electrical connection contact of the diode.

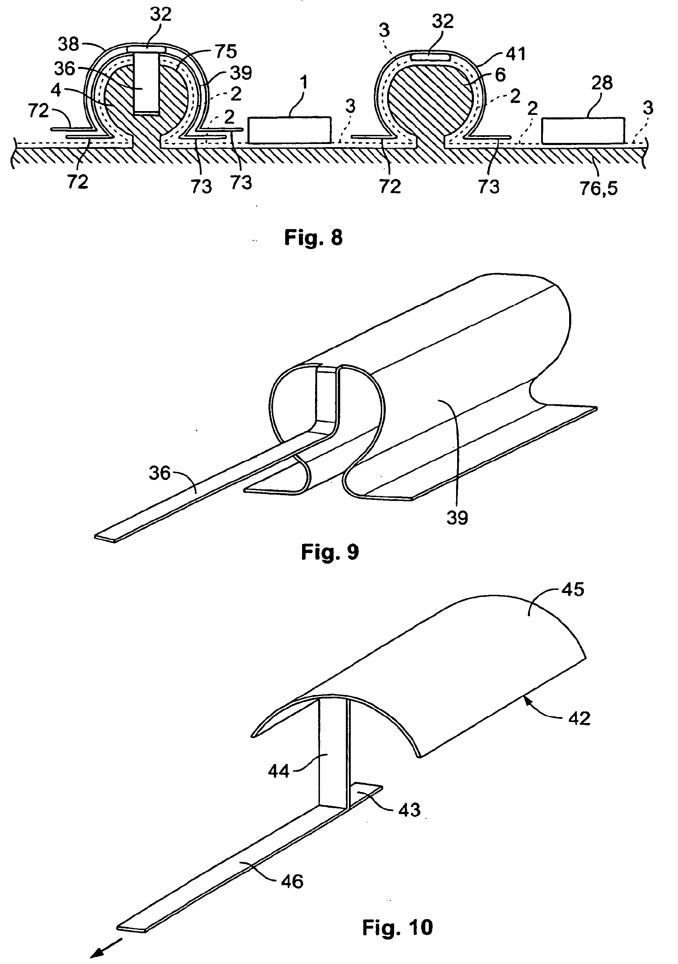

Figure 2 illustrates a third clamping element 41 (a first and a second clamping element 38, 39 will be described with reference to Figure 8) with basically an Q -shape, whereby the third clamping element 41 is used for fixing foil strips 2, 3 to guiding elements. The third clamping element has a shape of a cylindrical sleeve with a sleeve slit 70, whereby opposite sidewalls 71, 72 adjoining the slit 70 are bent away from the slit 70. The slit 70 is arranged in parallel to a longitudinal axis of the third clamping element 41. End parts 73, 74 of the side walls 71, 72 are arranged in one plane. The third clamping element 41 has a cross-sectional shape of said letter Q (omega) perpendicular to the longitudinal axis. In a simple embodiment, the third clamping element 41 may have a cross-sectional shape in the form of the letter U.

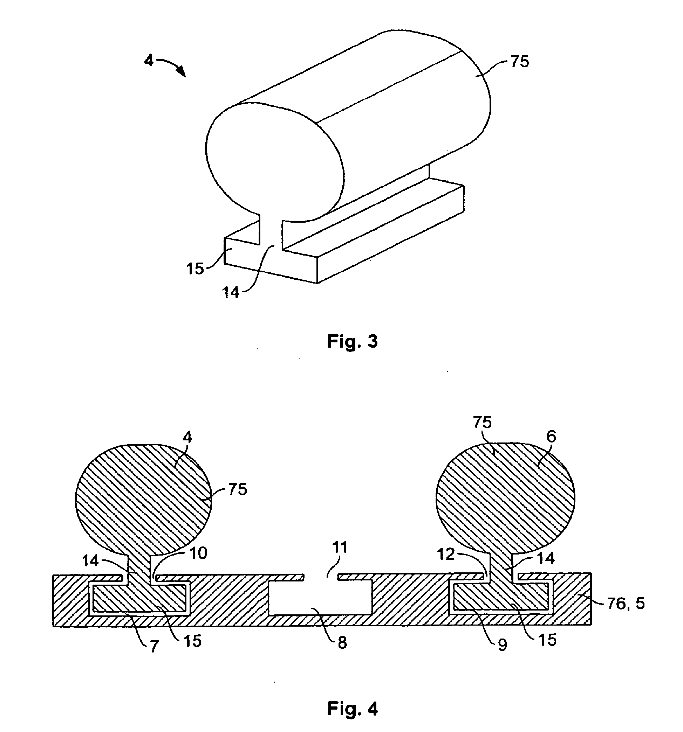

Using the third clamping element 41 and the foil strips 2, 3 reduces the costs of a junction box. An advantage of using the foil strips is that in vertical direction the bended foil strip is small. Therefore, the foil strip density on the junction box can be increased. Another advantage of the foil strip is that the foil strip may function as a cooling device providing a large cooling surface for the diode 1. Therefore, the cooling surface of diode 1 is improved. Additionally, the foil strip 2, 3 can easily be guided by bending the foil strip over a guiding element which is shown in Figure 3.

Figure 3 depicts a guiding element 4 which can be used for guiding and fixing the foil strips 2, 3. The guiding element 4 comprises a spherical guiding surface 75, preferably a cylindrical surface. The foil strip 2, 3 can be bent over the spherical guiding surface 75 lying at least partially on the guiding surface 75 of the guiding element 4. The guiding element may have a cylindrical shape with a diameter of about 6 to 8 mm with a length of 10 mm. Depending on the used embodiment, the guiding element 4 may be fixed to the housing in a stationary manner or fixed to the housing of the junction box in a moveable manner as schematically shown in Figure 4. The guiding element 4 as shown in figure 3 further comprises a foot plate 15 connected to the guiding surface 75 via a bar 14.

Figure 4 shows a schematic cross-sectional view of a section of a housing 5 of a junction box. The housing 5 comprises a base plate 76 in which parallel recesses 7, 8, 9 are arranged. The recesses 7, 8, 9 have a rectangular shape, whereby a slit 10, 11, 12 is arranged on an upper side. The first, second, third recess 7, 8, 9 extend along a predetermined distance and the slits 10, 11, 12 extend along the predetermined distance, as well, whereby the first, second and third slit 10, 11, 12 are arranged in parallel. Figure 4 shows the guiding element 4 and a second guiding element 6. The two guiding elements 4, 6 have the same shape with guiding surfaces 75 for guiding foil strips 2, 3 having a cylindrical shape whereby the guiding surfaces 75 are connected to said foot plate 15 via said bar 14. The foot plate 15 is guided in the respective recess 7, 8, 9. Therefore, the guiding elements 4, 6 are fixed to the housing 5 in a slidable manner. The slidable connection between the guiding elements 4, 6 is a T-rail system, which allows a movement of the guiding elements 4, 6 along the slits 10, 11, 12.

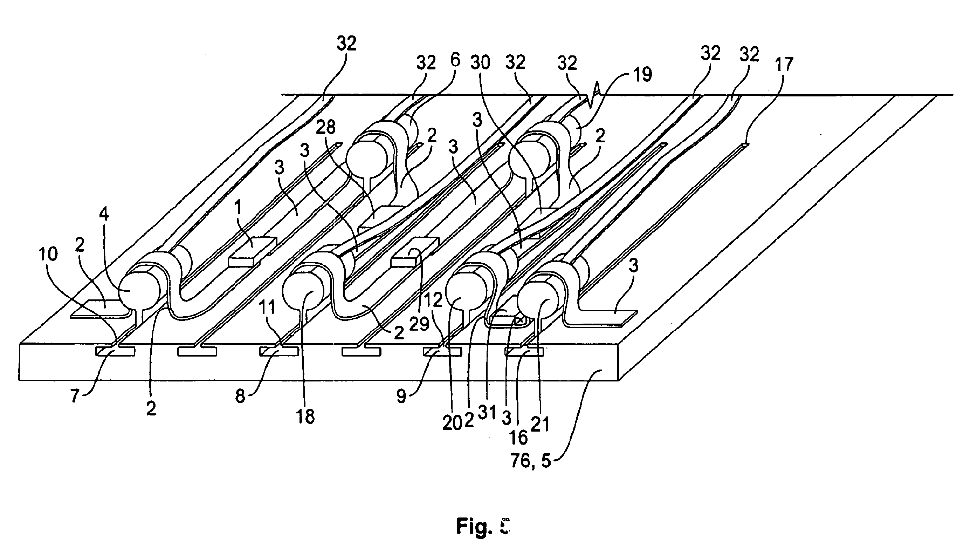

Figure 5 depicts a schematic view of a section of a junction box 35 for connecting solar cells with a housing 5 whereby only a base plate 76 is depicted. The housing 5 comprises four parallel recesses 7, 8, 9, 16 with four slits 10, 11, 12, 17. In each of the recesses 7, 8, 9, 16, a guiding element 4, 6, 18 to 21 is arranged in a moveable manner. Furthermore, a first, second, third, fourth and a fifth diode 1, 28 to 31 are arranged, whereby each diode 1, 28 to 31 comprises a first and a second foil strip 2, 3. The foil strips 2, 3 of the diodes are guided to respective guiding elements 4, 6, 8 to 21. The foil strips 2, 3 are fixed to the guiding elements 4, 6, 18 to 21. Additionally, foil conductors 32 of solar cells are connected to the foil strips 2, 3 on the guiding elements 4, 6, 18 to 21.

The first foil strip 2 that is fixed to the guiding element 4 and the first foil strip 2 that is fixed to the sixth guiding element 21 are connected to contact points of the junction box 35. The contact points are disposed for being connected to electrical conductors to deliver current that is produced by the solar cells.

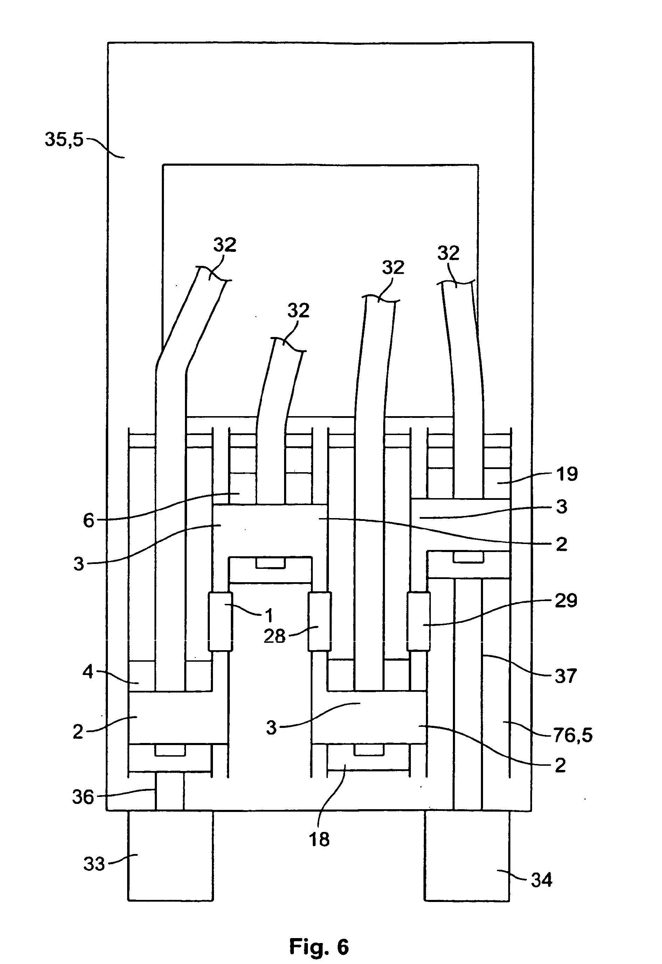

Figure 6 depicts a top view of a further embodiment of a junction box 35, which comprises three diodes 1, 28, 29 with foil strips 2, 3 whereby the foil strips 2, 3 are fixed to guiding elements 4, 6, 18, 19. In the depicted embodiment, four guiding elements 4, 6, 18, 19 are arranged. The first guiding element 4 and the fourth guiding element 19 are connected via conductor elements with contact points 33, 34. The three diodes are arranged with a small side on a base plate 76 of the housing 5.

The guiding elements 4, 6, 18, 19 of the embodiment of Figure 6 may be fixed to the housing 5 in a moveable manner or in a slidable manner. Each diode 1, 28, 29 comprises a first and a second foil strip 2, 3, whereby the foil strips 2, 3 of a diode are guided to different guiding elements 4, 6, 18, 19.

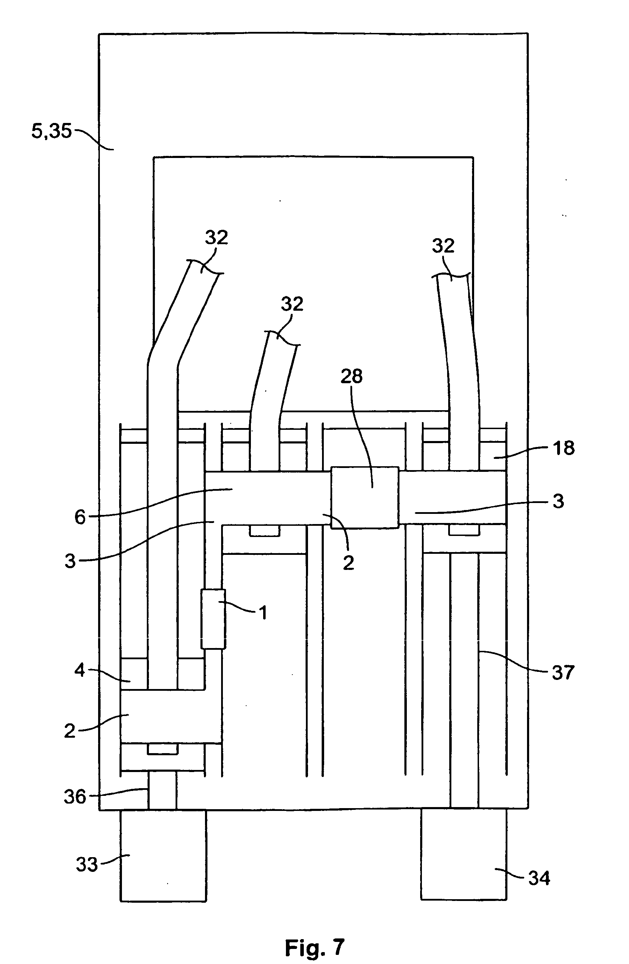

Figure 7 shows a top view of a further embodiment of a junction box 35, whereby only three guiding elements 4, 6 18 are disposed whereby only two diodes 1, 28 are arranged. The first diode 1 is arranged with a small side on the base plate 76 of the housing 5. The second diode 28 is arranged with a large bottom side on the base plate 76 of the housing 5. Each diode 1, 28 comprises a foil strip 2, 3 which is guided to a guiding element 4, 6, 18. The first guiding element 4 and the third guiding element 18 are connected via a first and a second conductor element 36, 37 with a first and a second contact point 33, 34. In the depicted embodiment, the first contact point 33 disposes the positive terminal of the junction box 35 and the second contact point 34 disposes the negative terminal of the junction box 35.

In the depicted embodiment, three foil conductors 32 of solar cells are guided to the three guiding elements 4, 6, 18, whereby the foil conductors 32 are electrically connected to the foil strips 2, 3 of the diodes 1, 6.

Figure 8 shows a cross-sectional view of the first and second guiding element 4, 6 of the junction box 35 of Figure 6.

A first foil strip 2 is guided from the first diode 1 to the guiding element 4. The guiding element 4 comprises a cylindrical guiding surface 75 to which the foil strip 2 is attached by means of a second clamping element 39.

A foil conductor 32 is arranged on the second clamping element 39. A first clamping element 38 is attached onto the second clamping element 39 fixing the foil conductor 32 onto the second clamping element 39. The second clamping element 39 is made of electroconductive material and comprises a first conductor element 36 which is guided to the first contact point 33 and connected to the first contact point 33.

A second foil strip 3 of the first diode 1 is guided to the second guiding element 6 and attached to the cylindrical guiding surface 75 of the second guiding element 6. On an upper side of the second guiding element 6, a foil conductor 32 is disposed on the second foil strip 3. A third clamping element 41 is arranged on the second guiding element 6 fixing the foil conductor 32 onto the second foil strip 3 of the first diode 1. The second diode 28 comprises a first and a second foil strip 2, 3, whereby the first foil strip 2 is guided to the second guiding element 6 and at least partially bent over the guiding surface 75 of the second guiding element 6. The second foil strip 3 of the first diode 1 and the first foil strip 2 of the second diode 28 may overlap being directly in contact. In another embodiment, the second foil strip 3 of the first diode 1 and the first foil strip 2 of the second diode 28 may only cover different parts of the guiding surface 75 being connected by the electroconductive third clamping element 41. The third clamping element 41 connects the first and the second foil strip 2, 3 of the second or respectively the first diode 28, 1 with the foil conductor 32. However, the foil conductor 32 may directly lie on the first and/or second foil strip 2, 3. The first and the third clamping element 38, 41 may have the same shape. The first and the third clamping element 38, 41 may preferably have at least partially the same shape in cross-section as the guiding surface 75 of the respective guiding element 4, 6. This allows to push the first and/or the second foil strip 2, 3 with a large face against the guiding surface 75, against each other and against the first and/or third clamping element 38, 41. The result is a strong fastening of the foil strips on the guiding elements 4, 6 and a good electrical connection between the foil strips 2, 3 and between a foil strip and a clamping element 38, 41. The end ports 73, 74 of the clamping elements allow to press the foil strip 2, 3 against the base plate 76. This improves the fastening of the foil strips 2, 3.

In the embodiment shown in Figure 8, the guiding element 4 and the second guiding element 6 are fixed to the housing 5 in an unmovable manner. Depending on the embodiment, the guiding element 4 and the second guiding element 6 may also be fixed to the housing 5 in a slidable manner, as explained in the embodiment of Figure 5.

Figure 9 shows a second clamping element 39 which has basically the shape of the first clamping element 38 of Figure 2, whereby the first conductor element 36 extends from an upper part of the second clamping element 39. The first conductor element 36 has the shape of a small stripe which is disposed for contacting the first or the second contact point 33, 34.

Figure 10 depicts a further embodiment of a fourth clamping element 42. The fourth clamping element 42 comprises a fixing part 43 which is fixed to a respective guiding element. The fixing part 43 is connected by means of a connecting strip 44 with a contact part 45. The contact part 45 may preferably have a spherical or a partially cylindrical shape. The contact part 45 is used for electrically contacting the foil strips 2, 3 and/or for fastening the foil strips 2, 3 to the guiding element. Additionally, the connecting strip 44 is connected to a second connecting strip 46 which is disposed for contacting a first and/or a second contact point 33, 34.

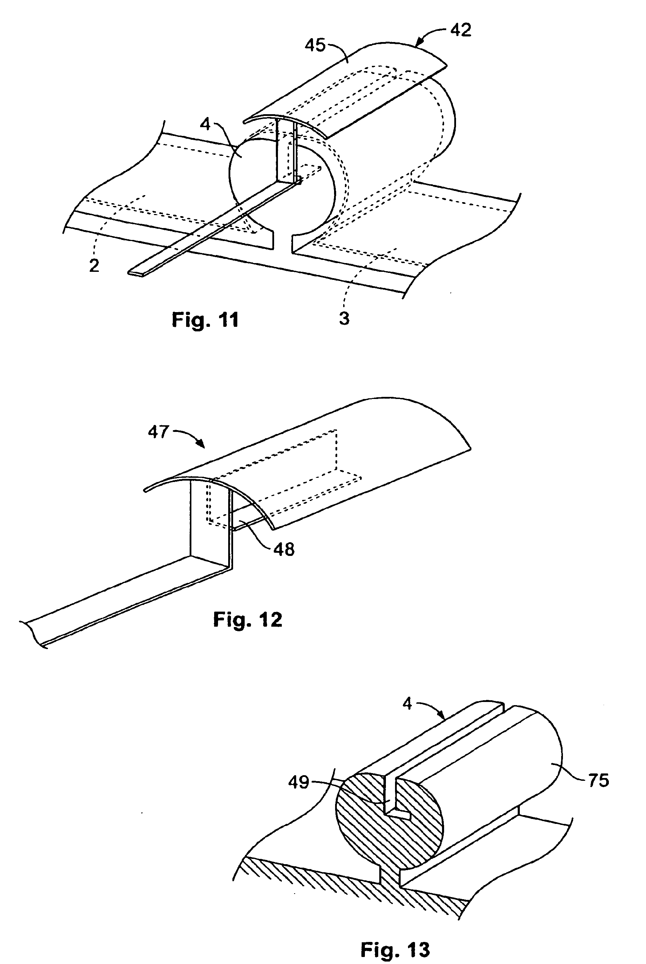

Figure 11 depicts a fourth clamping element 42 which is fixed to a first guiding element 4, whereby between the contact part 45 and the guiding element 4 a first and a second foil strip 2, 3 are disposed that overlap under the contact part 45. The contact part 45 is pushed by the connecting strip 44 against the first and/or second foil strip 2, 3.

Figure 12 depicts a fifth clamping element 47 which comprises basically the same shape as the fourth clamping element 42, whereby a second fixing part 48 is not arranged at a side face of the contact part 45 but is arranged at a lower face of the contact part 45. The second fixing part 48 has a cross-sectional shape of an L which is arranged and fastened in a mounted position in an L-shaped recess 49 of a guiding element 4 as depicted in Figure 13. In this embodiment, the first and second foil strips 2, 3 are guided from two opposite sides on the guiding surface 75 of the guiding element 4 until the second fixing part 48 and are electrically connected to each other via the contact part 45.

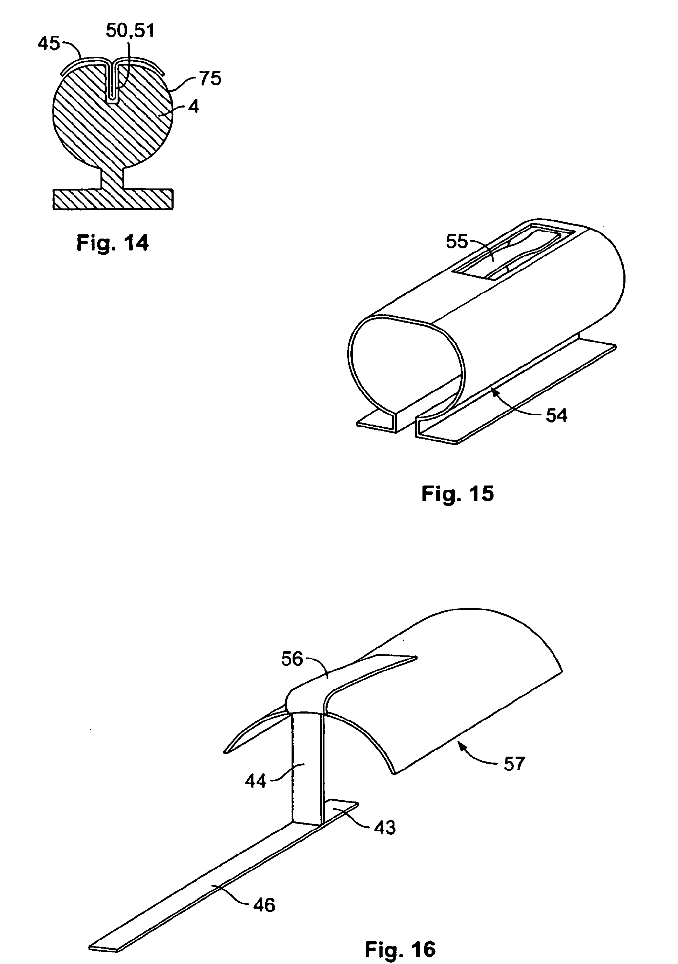

Figure 14 shows a further embodiment of a sixth clamping element 50 which has a third fixing part 51 in the shape of a bar which extends from a lower side of a contact part 45. The third fixing part 51 is arranged in a respective recess after the guiding element 4 and is fixed with the guiding element 4. The contact part 45 is pre-tensioned on the guiding surface 75 of the guiding element 4. For fixing and electrically connecting a first and a second foil strip 2, 3 of two different diodes 1, 28, the first and the second foil strip 2, 3 are arranged at opposite sides of the third fixing part 51 between the contact part 45 and the guiding surface 75 of the guiding element 4.

Figure 15 shows a seventh clamping element 54 which has basically the same shape as the first clamping element 38 whereby on an upper face of the seventh clamping element 54 a further contacting strip 55 is disposed which is bent back on the upper face of the seventh clamping element 54. The further contact strip 55 is used for contacting a further conductor, e.g. a foil conductor 32.

Figure 16 shows an eighth clamping element 57 which has basically the shape of the clamping element of Figure 10 whereby on an upper side an additional contact part 56 is disposed in the shape of a clip.

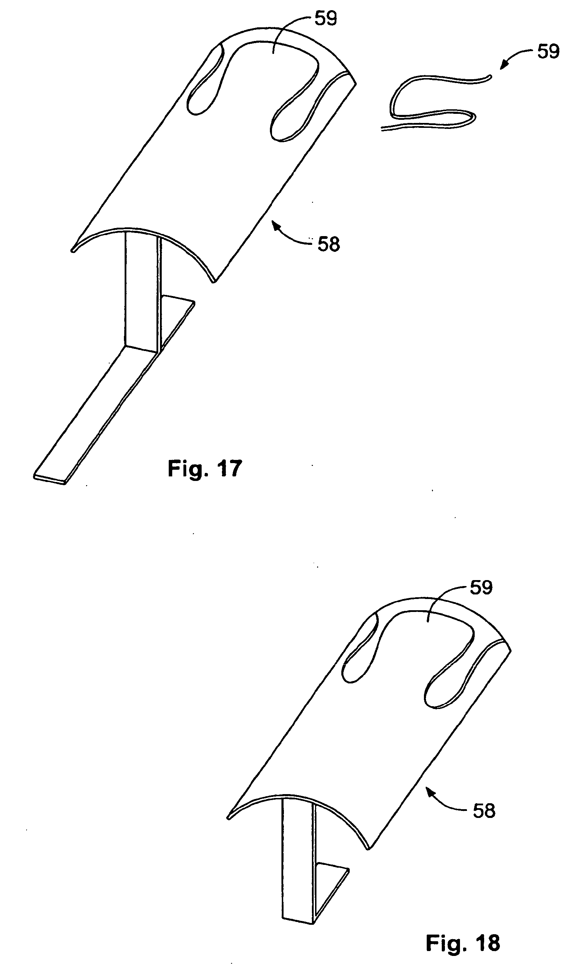

Figure 17 shows a ninth clamping element 58 which has basically the same shape as the fourth clamping element 42 of Figure 10 and additionally comprises an S-bended second clip 59 on an upper face for electrically contacting a further conductor, for example a foil conductor 32 of a solar cell. The second clip 59 is depicted in a separate drawing.

Figure 18 shows a ninth clamping element 58, whereby the second connecting strip 46 is not arranged.

The disclosed clamping elements may be made of electroconductive material, e.g. steel, preferably spring steel. However, the clamping elements could also be made of plastic.

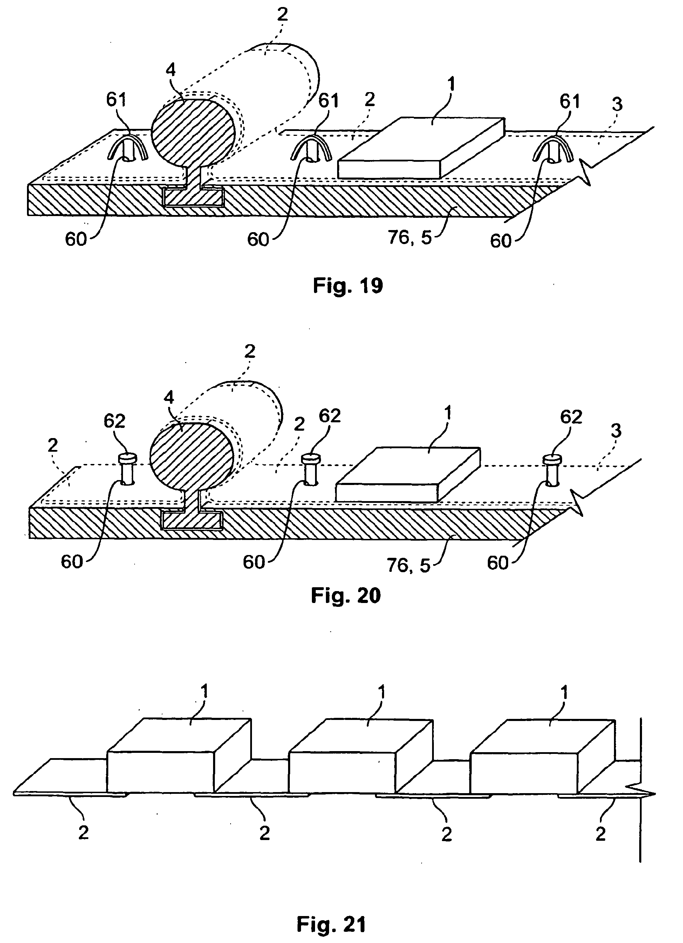

Figure 19 illustrates first fixing means for fixing the first and/or second foil strip 2, 3 to the housing 5. In this first embodiment, the foil strips comprise openings 60 into which plastic clips 61 in the shape of barbed hooks extend. The plastic clips 61 are fixed to the base plate 76 of the housing 5. Therefore, the first and the second foil strip 2, 3 are fixed onto a base plate of the housing 5 by plastic clips.

Figure 20 shows second fixing means for fixing the first and/or the second foil strip 2, 3 to the housing 5. In this embodiment, pins 62 extend from the base plate 76 and are guided through the opening 60 of the first and/or the second foil strip 2, 3 whereby the pins 62 can be glued to the foil strip 2/3 or the pins 62 are made of plastic and can thus be melted in a section above the foil strip 2, 3 to broaden the diameter and to fix the first and the second foil strip to the housing 5.

In a further embodiment, the foil strips 2, 3 may be glued onto the housing and/or the guiding elements.

According to another embodiment as shown in figure 21, two adjacent diodes 1 are connected by a single foil strip 2. By using such a configuration of diodes the clamping elements as described with regard to figure 8 would clamp a single foil strip while connecting said foil strip to the foil conductor 32. The diodes 1 according to this embodiment are thus connected to a single foil strip 2 thereby providing a diode chain.

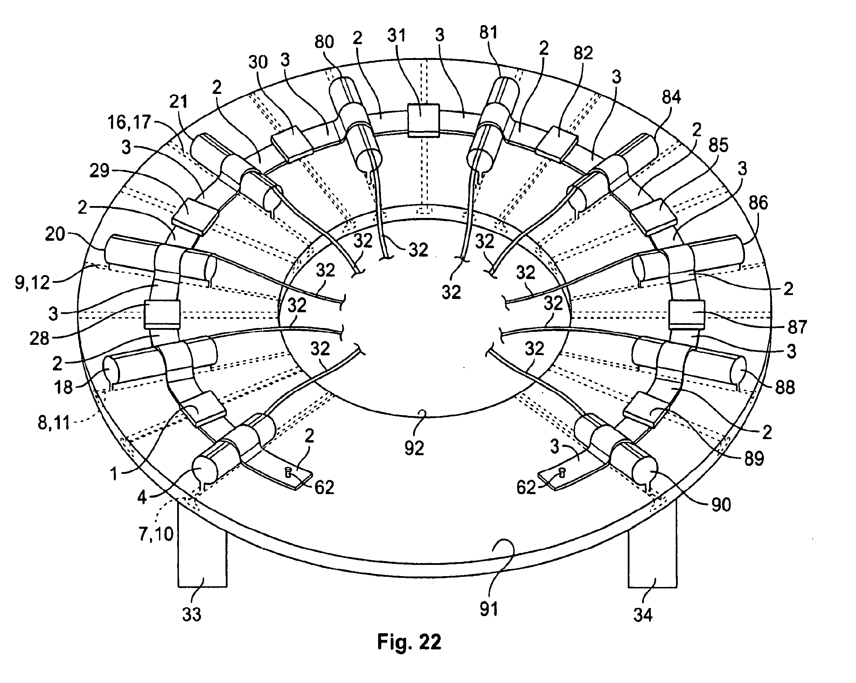

Figure 22 shows an embodiment of a further base plate 91 of a housing which has the shape of a ring plate with a central opening 92. Several foil conductors 32 of solar cells are guided through the central opening 92 to the guiding elements 4, 8, 20, 21, 80, 81, 84, 86, 88, 90. The guiding elements may all have the same structure and form as the guiding element 4 of figure 3. The guiding elements may be moveably connected to the further base plate 91 via recesses 7, 8, 9, 16 and respective slits 10, 11, 12, 17 as explained in the embodiment of figure 5. In the depicted embodiment of figure 22, the guiding elements are moveably connected to the further base plate 91 in radial directions referring to a center point of the central opening 92. The diodes 1, 28, 29, 30, 31, 82, 85, 87, 89 are disposed in a chain with the shape of a ring around the center point of the central opening 92. The diodes 1, 28, 29, 30, 31, 82, 85, 87, 89 are connected by first and second foil strips 2, 3. In a further embodiment, the guiding elements 4, 8, 20, 21, 80, 81, 84, 86, 88, 90 may be fixed to the further base plate 91 of a housing of a junction box fixed in an immobile manner.

The first foil strip 2 at one end of the diode chain and the second foil strip 3 at another end of the diode chain are fixed to the further base plate 91 by pins 62. The first foil strip 2 of the first end of the diode chain and the second foil strip 3 at the second end of the diode chain dispose two electrical contacts that may be connected to a first and second contact point.

The foil strips 2, 3 of the diodes 1, 28, 29, 30, 31, 82, 85, 87, 89 are guided by the surface of the guiding elements 4, 18, 20, 21, 80, 81, 84, 86, 88, 90. The foil strips 2, 3 may be fixed to the guiding elements, for example by gluing or by clamping elements as discussed in the figures 8 to 18. The clamping elements are not shown in figure 22. Furthermore, the foil strips 2, 3 are electrically connected to the foil conductors 32 at the guiding elements 4, 18, 20, 21, 80, 81, 84, 86, 88, 90. The embodiment of figure 22 provides an improved thermal distribution of the heat that is generated by the diodes.

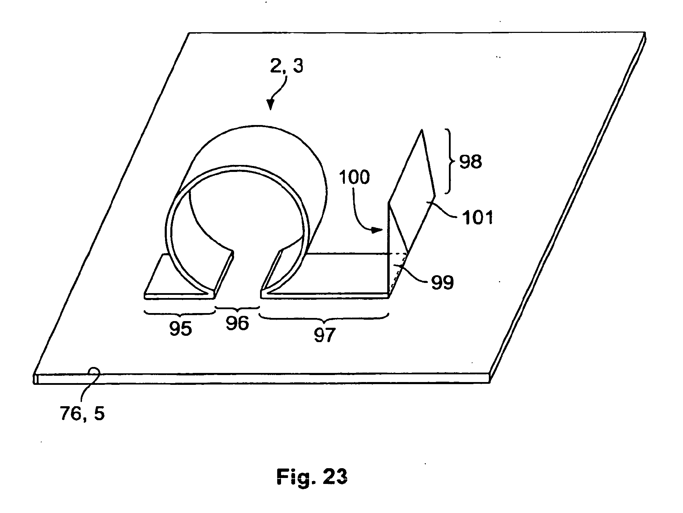

Figure 23 depicts an embodiment of a foil strip 2, 3. The embodiment of figure 23 shows the flexibility and the designability of the foil strip. The foil strip comprises a first section 95 in which it is arranged in parallel to a base plate 76 of a housing of a junction box. The first section 95 passes over to a second section 96 in which the foil strip has the shape of a partial ring. The second section 96 passes over to a third section 97 in which the foil strip is arranged in parallel to the first section 95 and preferably in the same plane as the first section 95. Thus the first, second and third section 95, 96, 97 dispose the shape of an Ω (omega).

The third section 97 extends to a fourth section 98, whereby in the fourth section 98 the foil strip is arranged with a small side face on the base plate 76.

The third section 97 goes over to the fourth section 98 over a folded section 99. In the folded section 99 the lower face of the third section 97 is folded to a left side 100 of the fourth section 98 which is disposed at the side of the third section. The upper side of the second section is folded to a right side 101 of the fourth section 98 which is opposite to the omega (Ω)-shape of the first, second and third section 95, 96, 97.

The embodiment of figure 23 shows how bendable the foil strips are and what different shapes the foil strip may have. The foil strip is made of a bendable material and can be formed in predetermined shapes by bending, whereby the foil strip stays in the bended form as shown in figure 23. Therefore, it is not always necessary to use guiding elements for guiding the foil strips. Depending on the used embodiment, the foil strips can be used without guiding elements for contacting electrical diodes as explained with the previous figures. The foil strip may be made of a thin electro-conductive foil which is for example made of metal.

The proposed invention has the advantage that a junction box for solar cells is proposed, whereby guiding elements and diodes, preferably Schottky diodes with legs made from foil strips or surface mounted diodes soldered onto foil strips are used. The foil strips have the advantage that they are flexible and need less space. Further advantages are that the costs of producing the junction box are reduced. A further advantage is that by using moveable guiding elements, different designs can be devised with the same junction box. Additionally, the stress on the diodes due to bending is reduced by using foil strips as contacts. Furthermore, an improved cooling is achieved by the foil strips. Furthermore, a low profile design is possible.

## Claims

1. Junction box (35) for connecting a solar cell, with a housing (5, 76) with an electrical diode, whereby the diode (1, 28-31) comprises electrical connection contacts, **characterized in that**
at least one of the electrical connection contacts is an electroconductive diode foil strip (2, 3), and
said diode foil strip (2, 3) is guided over a diode foil strip guiding surface (75) of a guiding element (4, 6, 18-21) that is connected to the housing (5, 76), whereby the diode foil strip (2, 3) is fixed to the guiding element (4, 6, 18-21).

2. Junction box of claim 1, whereby the diode foil strip (2, 3) is fixed to the housing (5, 76).

3. Junction box of claim 1 or 2, whereby the guiding element is connected to the housing (5, 76) in a slidable manner.

4. Junction box of claim 3, whereby the housing (5) comprises a base plate (76) with a guiding recess (7, 8, 9, 16) that extends along a slide direction, whereby the guiding recess (7, 8, 9, 16) is open to an upper side of the base plate by means of a slit (10, 11, 12, 17), whereby the slit (10, 11, 12, 17) extends along the slide direction, whereby a cross section of the guiding recess perpendicular to the slide direction is larger than a width of the slit, whereby the guiding element (4, 6, 18-21) comprises a foot plate (15) that is arranged in the guiding recess (7, 8, 9, 16) and that the foot plate (15) is broader than the slit, whereby the foot plate (15) guides the guiding element (4, 6, 18-21) in the guiding recess (7, 8, 9, 16) in a slidable manner along the slide direction.

5. Junction box of any of the preceding claims, whereby the guiding element (4, 6, 18-21) has at least partially a spherical guiding surface (75), preferably a cylindrical surface, whereby the diode foil strip (2, 3) is attached to the guiding surface (75).

6. Junction box of claim 1, whereby the guiding element is stationary fixed to the housing.

7. Junction box of any one of the claims 1 to 6, whereby a conductor (32) of the solar cell is connected to the diode foil strip (2, 3).

8. Junction box of claim 7, whereby the conductor (32) of the solar cell is fixed to the guiding element (4, 6, 18-21) preferably by means of a clamping element (38, 39, 41, 42).

9. Junction box of any one of the preceding claims, whereby a clamping element (38, 39, 41, 42) is fixed to the guiding element (4, 6, 18-21) and electrically connected to the diode foil strip (2, 3), whereby the clamping element (38, 39, 41, 42) has a connecting strip (36, 37) that is connected to an electrical contact point (33, 34).

10. Junction box of any one of the preceding claims, whereby a conductor element (36, 37) is arranged at the guiding element (4, 6, 18-21), whereby the conductor element (36, 37) is partially arranged in the guiding element (4, 6, 18-21) and fixed to the guiding element (4, 6, 18-21), whereby the conductor element (36, 37) is in contact with the diode foil strip (2, 3) and guided to a contact point (33, 34).

11. Junction box of any one of the claims 1 to 10, whereby the diode foil strip (2, 3) is fixed to the housing (5, 76) with a pin or clip (61, 62), whereby the pin or clip (61, 62) protrudes the diode foil strip (2, 3).

## Patentansprüche

1. Verteilerdose (35) zum Anschließen einer Solarzelle, mit einem Gehäuse (5, 76) mit einer elektrischen Diode, wobei die Diode (1, 28-31) elektrische Anschlusskontakte umfasst,
**dadurch gekennzeichnet, dass**
wenigstens einer der elektrischen Anschlusskontakte ein elektrisch leitfähiger Dioden-Folienstreifen (2, 3) ist und
der Dioden-Folienstreifen (2, 3) über eine Dioden-Folienstreifen-Führungsfläche (75) eines Führungselements (4, 6, 18-21) geführt wird, das mit dem Gehäuse (5, 76) verbunden ist, wobei der Dioden-Folienstreifen (2, 3) an dem Führungselement (4, 6, 18-21) befestigt ist.

2. Verteilerdose nach Anspruch 1, wobei der Dioden-Folienstreifen (2, 3) an dem Gehäuse (5, 76) befestigt ist.

3. Verteilerdose nach Anspruch 1 oder 2, wobei das Führungselement auf eine verschiebbare Weise mit dem Gehäuse (5, 76) verbunden ist.

4. Verteilerdose nach Anspruch 3, wobei das Gehäuse (5) eine Grundplatte (76) mit einer Führungsaussparung (7, 8, 9, 16), die sich längs einer Verschiebungsrichtung erstreckt, umfasst, wobei die Führungsaussparung (7, 8, 9, 16) mit Hilfe eines Schlitzes (10, 11, 12, 17) zu einer oberen Seite der Grundplatte offen ist, wobei sich der Schlitz (10, 11, 12, 17) längs der Verschiebungsrichtung erstreckt, wobei ein Querschnitt der Führungsaussparung senkrecht zu der Verschiebungsrichtung größer ist als eine Breite des Schlitzes, wobei das Führungselement (4, 6, 18-21) eine Fußplatte (15) umfasst, die in der Führungsaussparung (7, 8, 9, 16) angeordnet ist, und die Fußplatte (15) breiter ist als der Schlitz, wobei die Fußplatte (15) das Führungselement (4, 6, 18-21) auf eine verschiebbare Weise längs der Verschiebungsrichtung in der Führungsaussparung (7, 8, 9, 16) führt.

5. Verteilerdose nach einem der vorhergehenden Ansprüche, wobei das Führungselement (4, 6, 18-21) wenigstens teilweise eine sphärische Führungsfläche (75), vorzugsweise eine zylindrische Fläche, hat, wobei der Dioden-Folienstreifen (2, 3) an der Führungsfläche (75) befestigt ist.

6. Verteilerdose nach Anspruch 1, wobei das Führungselement unbeweglich an dem Gehäuse befestigt ist.

7. Verteilerdose nach einem der Ansprüche 1 bis 6, wobei ein Leiter (32) der Solarzelle mit dem Dioden-Folienstreifen (2, 3) verbunden ist.

8. Verteilerdose nach Anspruch 7, wobei der Leiter (32) der Solarzelle vorzugsweise mit Hilfe eines Klemmelements (38, 39, 41, 42) an dem Führungselement (4, 6, 18-21) befestigt ist.

9. Verteilerdose nach einem der vorhergehenden Ansprüche, wobei ein Klemmelement (38, 39, 41, 42) an dem Führungselement (4, 6, 18-21) befestigt und elektrisch mit dem Dioden-Folienstreifen (2, 3) verbunden ist, wobei das Klemmelement (38, 39, 41, 42) einen Anschluss-Streifen (36, 37) hat, der mit einem elektrischen Kontaktpunkt (33, 34) verbunden ist.

10. Verteilerdose nach einem der vorhergehenden Ansprüche, wobei ein Leiterelement (36, 37) an dem Führungselement (4, 6, 18-21) angeordnet ist, wobei das Leiterelement (36, 37) teilweise in dem Führungselement (4, 6, 18-21) angeordnet und an dem Führungselement (4, 6, 18-21) befestigt ist, wobei sich das Leiterelement (36, 37) in Kontakt mit dem Dioden-Folienstreifen (2, 3) befindet und zu einem Kontaktpunkt (33, 34) geführt wird.

11. Verteilerdose nach einem der Ansprüche 1 bis 10, wobei der Dioden-Folienstreifen (2, 3) mit einem Stift oder einer Klammer (61, 62) an dem Gehäuse (5, 76) befestigt ist, wobei der Stift oder die Klammer (61, 62) über den Dioden-Folienstreifen (2, 3) vorspringt.

## Revendications

1. Boîte de jonction (35) pour connecter une cellule solaire, comportant un boîtier (5, 76) avec une diode électrique, la diode (1, 28-31) comprenant des contacts de connexion électrique,
**caractérisée en ce que**
au moins un des contacts de connexion électrique est un ruban métallique de diode conducteur d'électricité (2, 3), et
ledit ruban métallique de la diode (2, 3) étant guidé au-dessus d'une surface de guidage du ruban métallique de la diode (75) d'un élément de guidage (4, 6, 18-21) connecté au boîtier (5, 76), le ruban métallique de la diode (2, 3) étant fixé sur l'élément de guidage (4, 6, 18-21).

2. Boîte de jonction selon la revendication 1, dans laquelle le ruban métallique de la diode (2, 3) est fixé sur le boîtier (5, 76).

3. Boîte de jonction selon les revendications 1 ou 2, dans laquelle l'élément de guidage est connecté au boîtier (5, 76) de manière coulissante.

4. Boîte de jonction selon la revendication 3, dans laquelle le boîtier (5) comprend une plaque de base (76) avec un évidement de guidage (7, 8, 9, 16) s'étendant le long d'une direction de glissement, l'évidement de guidage (7, 8, 9, 16) étant ouvert vers un côté supérieur de la plaque de base par l'intermédiaire d'une fente (10, 11, 12, 17), la fente (10, 11, 12, 17) s'étendant le long de la direction de glissement, une section transversale de l'évidement de guidage perpendiculaire à la direction de glissement étant plus grande qu'une largeur de la fente, l'élément de guidage (4, 6, 18-21) comprenant une plaque de support (15), agencée dans l'évidement de guidage (7, 8, 9, 16), la plaque de support (15) étant plus large que la fente, la plaque de support (15) guidant l'élément de guidage (4, 6, 18-21) dans l'évidement de guidage (7, 8, 9, 16) d'une manière coulissante le long de la direction de glissement.

5. Boîte de jonction selon l'une quelconque des revendications précédentes, dans laquelle l'élément de guidage (4, 6, 18-21) comporte au moins partiellement une surface de guidage sphérique (75), de préférence une surface cylindrique, le ruban métallique de la diode (2, 3) étant fixé sur la surface de guidage (75).

6. Boîte de jonction selon la revendication 1, dans laquelle l'élément de guidage est fixé de manière stationnaire sur le boîtier.

7. Boîte de jonction selon l'une quelconque des revendications 1 à 6, dans laquelle un conducteur (32) de la cellule solaire est connecté au ruban métallique de la diode (2, 3).

8. Boîte de jonction selon la revendication 7, dans laquelle le conducteur (32) de la cellule solaire est de préférence fixé sur l'élément de guidage (4, 6, 18-21) par l'intermédiaire d'un élément de serrage (38, 39, 41, 42).

9. Boîte de jonction selon l'une quelconque des revendications précédentes, dans laquelle un élément de serrage (38, 39, 41, 42) est fixé sur l'élément de guidage (4, 6, 18-21) et connecté électriquement au ruban métallique de la diode (2, 3), l'élément de serrage (38, 39, 41, 42) comportant une plaquette de connexion (36, 37) connectée à un point de contact (33, 34).

10. Boîte de jonction selon l'une quelconque des revendications précédentes, dans laquelle un élément conducteur (36, 37) est agencé au niveau de l'élément de guidage (4, 6, 18-21), l'élément conducteur (36, 37) étant en partie agencé dans l'élément de guidage (4, 6, 18-21) et fixé à l'élément de guidage (4, 6, 18-21), l'élément conducteur (36, 37) étant en contact avec le ruban métallique de la diode (2, 3) et étant guidé vers un point de contact (33, 34).

11. Boîte de jonction selon l'une quelconque des revendications 1 à 10, dans laquelle le ruban métallique de la diode (2, 3) est fixé sur le boîtier (5, 76) par une broche ou une pince (61, 62), la broche ou la pince (61, 62) débordant à travers le ruban métallique de la diode (2, 3).
